(19) **Europäisches Patentamt**
**European Patent Office**
**Office européen des brevets**

(11) **EP 4 489 550 A1**

(12) **EUROPEAN PATENT APPLICATION**

(43) Date of publication:
**08.01.2025 Bulletin 2025/02**

(21) Application number: **24184842.3**

(22) Date of filing: **27.06.2024**

(51) International Patent Classification (IPC):
**H10K 59/40** (2023.01)    **H10K 59/80** (2023.01)
**H10K 59/88** (2023.01)    **H10K 77/10** (2023.01)

(52) Cooperative Patent Classification (CPC):
**H10K 77/111; H10K 59/40; H10K 59/873;**
**H10K 59/88;** H10K 2102/311

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **03.07.2023 KR 20230085573**

(71) Applicant: **Samsung Display Co., Ltd.**
**Yongin-si, Gyeonggi-do 17113 (KR)**

(72) Inventors:
• **KIM, Hyun**
**17113 Giheung-Gu, Yongin-si, Gyeonggi-do (KR)**

• **LEE, Seung Min**
**17113 Giheung-gu, Yongin-si, Gyeonggi-do (KR)**
• **KIM, Dong Jo**
**17113 Giheung-Gu, Yongin-si, Gyeonggi-do (KR)**
• **KIM, Young Ji**
**17113 Giheung-Gu, Yongin-si, Gyeonggi-do (KR)**
• **YOO, Je Won**
**17113 Giheung-Gu, Yongin-si, Gyeonggi-do (KR)**

(74) Representative: **Dr. Weitzel & Partner**
**Patent- und Rechtsanwälte mbB**
**Friedenstrasse 10**
**89522 Heidenheim (DE)**

(54) **DISPLAY DEVICE AND METHOD OF FABRICATING DISPLAY DEVICE**

(57)    A display device includes: a first substrate comprising a first surface and a second surface facing each other and having a rigid material; a second substrate on the first surface of the first substrate and having a flexible material; and a display layer on the second substrate and comprising at least one inorganic film and a plurality of light-emitting elements, wherein the first substrate, at an edge of a bending area where the second substrate is bent, further includes: a first side surface between the first surface and the second surface; and a first inclined surface between the first surface and the first side surface, and the at least one inorganic film does not overlap with the first inclined surface.

**EP 4 489 550 A1**

**Description**

**BACKGROUND**

**1. Field**

Aspects of some embodiments of the present invention relate to a display device, and in particular a method of fabricating the same.

**2. Description of the Related Art**

As the information-oriented society evolves, consumer demand for display devices is ever increasing. Display devices include flat panel display devices such as a liquid-crystal display device, a field emission display device, and a light-emitting display device.

A display device generally includes a display area where images are displayed, and a non-display area around the display area, for example. Such a non-display area is a dead space. Recently, the width of the dead space is ever decreasing in order for viewers to get more immersed in the contents displayed on the display area and to increase the aesthetics of the display device.

In order to reduce the width of a non-display area, a bending area may be formed between a pad area and a display area, and the pad area may be positioned under a display panel when the bending area is bent. To this end, a substrate made of a flexible material that can be bent is used. As the size of the substrate increases, a substrate made of a rigid material may be further included in order to maintain the shape.

The above information disclosed in this Background section is only for enhancement of understanding of the background and therefore the information discussed in this Background section does not necessarily constitute prior art.

**SUMMARY**

The invention is defined by the independent claims. Aspects of some embodiments of the present invention include a display device in which the width of a dead space is relatively reduced, and a method of fabricating a display device.

Aspects of some embodiments of the present invention also include a display device in which an edge in a bending area is spaced apart from an end of an inorganic film group of a display panel, taking into account that the bending area is expanded due to an undercut, and a method of fabricating a display device.

Aspects of some embodiments of the present invention also include a display device that can prevent or reduce cracks in organic films of a display panel which may occur as a bending area is expanded due to an undercut and that can suppress operation failure of the display device due to such cracks, and a method of fabricating a display device.

It should be noted that characteristics of embodiments according to the present invention are not limited to the above-mentioned characteristics; and other objects of the present invention will be apparent to those skilled in the art from the following descriptions.

According to the present invention, a display device includes: a first substrate including a first surface and a second surface facing each other and having a rigid material; a second substrate on the first surface of the first substrate and having a flexible material; and a display layer on the second substrate and including at least one inorganic film and a plurality of light-emitting elements, wherein the first substrate, at an edge of a bending area where the second substrate is bent, further includes: a first side surface between the first surface and the second surface; and a first inclined surface between the first surface and the first side surface, and the at least one inorganic film does not overlap with the first inclined surface.

According to some embodiments, the at least one inorganic film does not overlap with the bending area.

According to some embodiments, the first substrate further comprises an opening exposing the second substrate, and the edge of the bending area is located on each of both sides of the opening.

According to some embodiments, an outermost end of the at least one inorganic film, the outermost end adjacent to the bending area, is spaced apart from a boundary where the first inclined surface meets the first surface by a first distance in a horizontal direction.

According to some embodiments, an end of the first substrate in the bending area is spaced apart from the outermost end of the at least one inorganic film by a second distance in the horizontal direction.

According to some embodiments, a length of the first inclined surface in the horizontal direction is a first length, and the second distance is equal to a sum of the first distance and the first length.

According to some embodiments, a minimum value of the second distance is equal to a sum of the first distance and an average of the first length.

According to some embodiments, the minimum value of the second distance is equal to 88 $\mu$m.

According to some embodiments, the first distance is equal to 14.2 $\mu$m, and the average of the first length is equal to 73.8 $\mu$m.

According to some embodiments, a distance between ends at edges of the first substrate in the bending area is a third distance, a maximum value of the second distance satisfies Equation 1 below,

$$[\text{Equation 1}] \ \text{Max(D2)} = \mu(L1) + 3\sigma(L1) + 3\sigma(D3),$$

and Max(D2) denotes the maximum value of the second distance, $\mu$(L1) denotes an average of the first length, $\sigma$(L1) denotes a deviation of the first length, and $\sigma$(D3) denotes a deviation of the third distance.

According to some embodiments, the maximum value of the second distance is equal to 415 $\mu$m.

According to some embodiments, the average of the first length is 73.8 $\mu$m, and a deviation of the first length is 12.1 $\mu$m.

According to some embodiments, the first distance satisfies Equation 2 below,

$$[\text{Equation 2}] \ \text{D1} = 3\sigma(L1) + 3\sigma(D3).$$

According to some embodiments, the deviation of the third distance satisfies Equation 3 below in a process of etching the first substrate located in the bending area, [Equation 3] , and wherein $\sigma$1 denotes a central axis deviation of a plotter configured to remove a part of a protective film attached on the second surface of the first substrate, and $\sigma$2 denotes a central axis deviation of an etchant supply configured to etch the first substrate.

According to some embodiments, a deviation of the third distance is equal to 101.5 $\mu$m.

According to some embodiments, the central axis deviation of the plotter is equal to 48.22 $\mu$m, and the central axis deviation of the etchant supply is equal to 89.32 $\mu$m.

According to some embodiments, the display device may further comprise, an encapsulation layer on the display layer and comprising at least one inorganic encapsulation film, wherein the at least one inorganic encapsulation film does not overlap with the first inclined surface.

According to some embodiments, the display device may further comprise, a sensor layer on the encapsulation layer and comprising at least one sensor inorganic film, wherein the at least one sensor inorganic film does not overlap with the first inclined surface.

According to some embodiments, the first substrate comprises glass, and the second substrate comprises a polymer resin.

According to another aspect of the present invention, a display device includes, a first substrate including a first surface and a second surface facing each other and having a rigid material, a second substrate on the first surface of the first substrate and having a flexible material, a display layer on the second substrate and including at least one display inorganic film and a plurality of light-emitting elements, an encapsulation layer on the display layer and including at least one encapsulation inorganic film, and a sensor layer on the encapsulation layer and including at least one sensor inorganic film, wherein the display inorganic film, the inorganic encapsulation film, and the sensor inorganic film constitute an inorganic film group, the first substrate, at an edge of a bending area where the second substrate is bent, further includes, a first side surface located between the first surface and the second surface, and a first inclined surface located between the first surface and the first side surface, and the inorganic film group does not overlap with the first inclined surface.

According to some embodiments, the inorganic film group may comprise the one inorganic film.

According to some embodiments, the inorganic film group does not overlap with the bending area.

According to some embodiments, the display device may further comprise, a display area in which the plurality of light-emitting elements is located, a non-display area between the display area and the bending area, a first dam between the plurality of light-emitting elements and the bending area, and a bank structure in at least one of the non-display area and the bending area.

According to some embodiments, the inorganic film group comprises a first inorganic film group and a second inorganic film group, the first inorganic film group is made up of the at least one display inorganic film, the second inorganic film group is made up of at least one of the at least one inorganic encapsulation film and the at least one sensor inorganic film, the first inorganic film group does not overlap with the bank structure, and the second inorganic film group overlaps with the bank structure.

According to some embodiments, the inorganic film group does not overlap with the bank structure.

According to some embodiments, an outermost end of the inorganic film group, the outermost end adjacent to the bending area, is spaced apart from a boundary where the first inclined surface meets the first surface by a first distance in a horizontal direction.

According to some embodiments, an end of the first substrate in the bending area is spaced apart from the outermost end of the inorganic film group by a second distance in the horizontal direction.

According to some embodiments, a length of the first inclined surface in the horizontal direction is a first length, and the second distance is equal to a sum of the first distance and the first length.

According to some embodiments, a minimum value of the second distance is equal to a sum of the first distance and an average of the first length.

According to some embodiments, a distance between ends at edges of the first substrate in the bending area is a third distance, a maximum value of the second distance satisfies Equation 1 below,

$$[Equation\ 1]\ Max(D2)=\mu(L1)+3\sigma(L1)+3\sigma(D3),$$

and Max(D2) denotes the maximum value of the second distance, $\mu(L1)$ denotes an average of the first length, $\sigma(L1)$ denotes a deviation of the first length, and $\sigma(D3)$ denotes a deviation of the third distance.

According to some embodiments, the first distance satisfies Equation 2 below,

$$[Equation\ 2]\ D1=3\sigma(L1)+3\sigma(D3).$$

According to some embodiments, the deviation of the third distance satisfies Equation 3 below in a process of etching the first substrate located in the bending area, [Equation 3] , and wherein $\sigma1$ denotes a central axis deviation of a plotter configured to remove a part of a protective film attached on the second surface of the first substrate, and $\sigma2$ denotes a central axis deviation of an etchant supply configured to etch the first substrate.

According to some embodiments of the present invention, the width of a dead space of a display device can be relatively reduced.

According to some embodiments of the present invention, an edge in a bending area can be spaced apart from an end of an inorganic film group of a display panel in a display device, taking into account that the bending area is expanded due to an undercut.

According to some embodiments of the present invention, it may be possible to prevent or reduce cracks in organic films of a display panel in a display device, which may occur as a bending area is expanded due to an undercut, and to suppress operation failure of the display device due to such cracks.

It should be noted that the characteristics of embodiments according to the present invention are not limited to those described above and other characteristics of embodiments according to the present invention will be more apparent to those skilled in the art from the following descriptions.

**BRIEF DESCRIPTION OF THE DRAWINGS**

The above and other aspects and features of embodiments according to the present invention will become more apparent by describing in more detail aspects of some embodiments thereof with reference to the attached drawings, in which:

FIG. 1 is a perspective view showing a display device according to some embodiments of the present invention.
FIG. 2 is a plan view showing a display panel and driver ICs according to some embodiments of the present invention.
FIG. 3 is a perspective view showing a display device according to some embodiments of the present invention.
FIG. 4 is a cross-sectional view showing an example of a display area of a display device according to some embodiments of the present invention.
FIG. 5 is a cross-sectional view taken along the line X1 - X1' in FIG. 1.
FIG. 6 is a cross-sectional view showing the display device of FIG. 5 when it is bent according to some embodiments of the present invention.
FIG. 7 is a cross-sectional view schematically showing a related-art display device.
FIG. 8 is a cross-sectional view showing the display device of FIG. 7 when it is bent.
FIG. 9 is an enlarged view of the portion A of FIG. 5 according to some embodiments of the present invention.
FIG. 10 is a graph showing distributions of distances between an end of a first substrate in a bending area and an end of an inorganic film group in experimental groups sorted by whether cracks occur in inorganic films.
FIG. 11 is a cross-sectional view showing a part of a display area, a non-display area and a bending area of a display device according to some embodiments of the present invention.
FIG. 12 is a flowchart for illustrating a method of fabricating a display device according to some embodiments of the present invention.
FIG. 13 is a cross-sectional view showing step S100 of FIG. 12.
FIG. 14 is a cross-sectional view showing step S200 of FIG. 12.

FIG. 15 is a cross-sectional view showing step S300 of FIG. 12.
FIG. 16 is a cross-sectional view showing step S400 of FIG. 12.
FIG. 17 is a cross-sectional view showing step S500 of FIG. 12.
FIG. 18 is a cross-sectional view showing step S600 of FIG. 12.

## DETAILED DESCRIPTION

Aspects of some embodiments of the present invention will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this invention will be thorough and complete, and will more fully convey the scope of embodiments according to the present invention to those skilled in the art.

It will also be understood that when a layer is referred to as being "on" another layer or substrate, it can be directly on the other layer or substrate, or intervening layers may also be present. The same reference numbers indicate the same components throughout the specification.

Hereinafter, aspects of some embodiments of the present invention will be described in more detail with reference to the accompanying drawings.

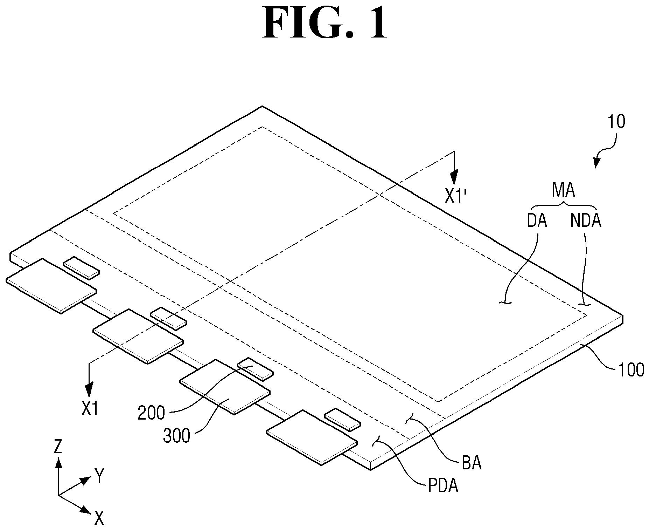

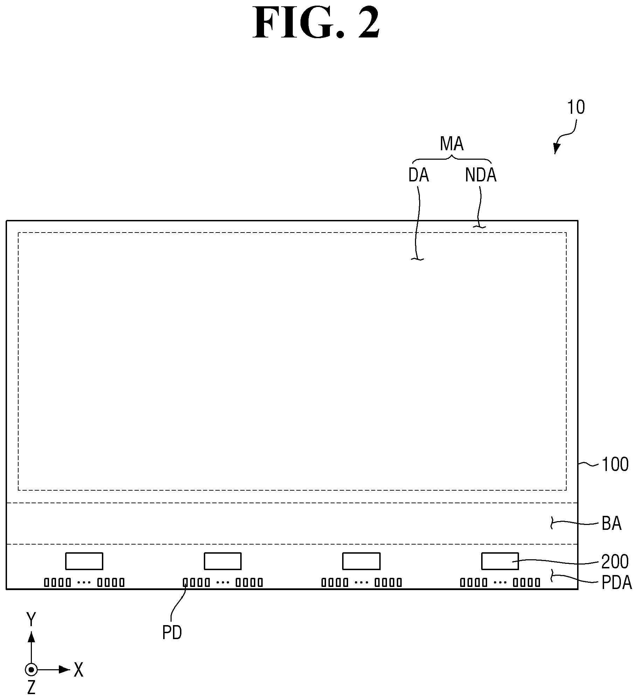

FIG. 1 is a perspective view showing a display device according to some embodiments of the present invention. FIG. 2 is a plan view showing a display panel and driver ICs according to some embodiments of the present invention.

Referring to FIGS. 1 and 2, a display device 10 according to some embodiments of the present invention is for displaying moving images or still images. The display device 1 may be used as the display screen of portable electronic devices such as a mobile phone, a smart phone, a tablet PC, a smart watch, a watch phone, a mobile communications terminal, an electronic notebook, an electronic book, a portable multimedia player (PMP), a navigation device and a ultra mobile PC (UMPC), as well as the display screen of various products such as a television, a notebook, a monitor, a billboard and the Internet of Things device.

According to some embodiments of the present invention, the display device 10 may be a light-emitting display device such as an organic light-emitting display device using organic light-emitting diodes, a quantum-dot light-emitting display device including quantum-dot light-emitting layer, an inorganic light-emitting display device including an inorganic semiconductor, and a micro-LED display device using micro or nano light-emitting diodes (micro LEDs or nano LEDs). In the following description, an organic light-emitting display device is described as an example of the display device 10. It is, however, to be understood that embodiments according to the present invention are not limited thereto.

The display device 10 according to some embodiments may include a display panel 100, a driver integrated circuits (ICs) 200, and circuit boards 300.

The display panel 100 may be formed in a rectangular plane having longer sides in a first direction (x-axis direction) and shorter sides in a second direction (y-axis direction) intersecting the first direction (x-axis direction). Each of the corners where the longer side in the first direction (x-axis direction) meets the shorter side in the second direction (y-axis direction) may be formed at a right angle or may be rounded with a curvature. The shape of the display panel 100 when viewed from the top (e.g., in a plan view) is not limited to a quadrangular shape, but may be formed in a different polygonal shape, a circular shape, or an elliptical shape.

In the drawings, the first direction (x-axis direction) and the second direction (y-axis direction) intersect each other as the horizontal directions. For example, the first direction (x-axis direction) and the second direction (y-axis direction) may be orthogonal to each other. In addition, the third direction (z-axis direction) may intersect the first direction (x-axis direction) and the second direction (y-axis direction), and may be, for example, a vertical direction orthogonal to them. Herein, the side indicated by the arrow of each of the first to third directions (x-axis direction, y-axis direction and z-axis direction) may be referred to as a first side, while the opposite side may be referred to as a second side.

The display panel 100 may be formed flat, but embodiments according to the present invention are not limited thereto. For example, the display panel 100 may be formed at left and right ends, and may include a curved portion having a constant curvature or a varying curvature. In addition, the display panel 100 may be flexible so that it can be curved, bent, folded or rolled.

The display panel 100 may include a main area MA, a bending area BA, and a pad area PDA. The main area MA may include a display area DA where images are displayed, and a non-display area NDA around the display area DA.

The display area DA may occupy most of the area of the display panel 100. The display area DA may be located at the center of display device 100. In the display area DA, pixels each including a plurality of emission areas may be arranged to display images.

The non-display area NDA may be located adjacent to the display area DA. The non-display area NDA may be located on the outer side of the display area DA. The non-display area NDA may surround the display area DA. The non-display area NDA may be defined as the border of the display panel 100.

The bending area BA may be located between the display area DA and the pad area PDA in the second direction (y-axis direction). The bending area BA may be extended in the first direction (x-axis direction). The bending area BA may be bent such that it is located under the display panel 100. When the bending area BA is bent and located under the display panel 100, the plurality of driver ICs 200 and the circuit boards 300 may be located under the display panel 100.

The pad area PDA may be the lower edge area of the display panel 100. In the pad area PDA, display pads PD connected to the circuit boards 300, and first and second driving pads connected to the driver ICs 200 may be located.

In the pad area PDA, display pads DP may be arranged to be connected to the circuit boards 300. The display pads DP may be located at one edge of the display panel 100. For example, the display pads DP may be located at the lower edge of the display panel 100.

The driving integrated circuits (ICs) 200, also called as driver ICs 200, may generate data voltages, supply voltages, scan timing signals, etc. The driver ICs 200 may output data voltages, supply voltages, scan timing signals, etc.

The driver ICs 200 may be located in the pad area PDA. The driver ICs 200 may be located between the display pads PD and the display area DA in the non-display area NDA. The driver ICs 200 may be attached to the non-display area NDA of the display panel 100 by a chip on glass (COG) technique. Alternatively, the driver ICs 200 may be attached to the circuit boards 300, respectively, by a chip on plastic (COP) technique.

The circuit boards 300 may be located on the display pads DP located at one edge of the display panel 100. The circuit boards 300 may be attached to the display pads PD using a conductive adhesive member such as an anisotropic conductive film and an anisotropic conductive adhesive. Accordingly, the circuit boards 300 may be electrically connected to signal lines of the display panel 100. The circuit boards 300 may be flexible printed circuit boards, flexible films such as chip on films.

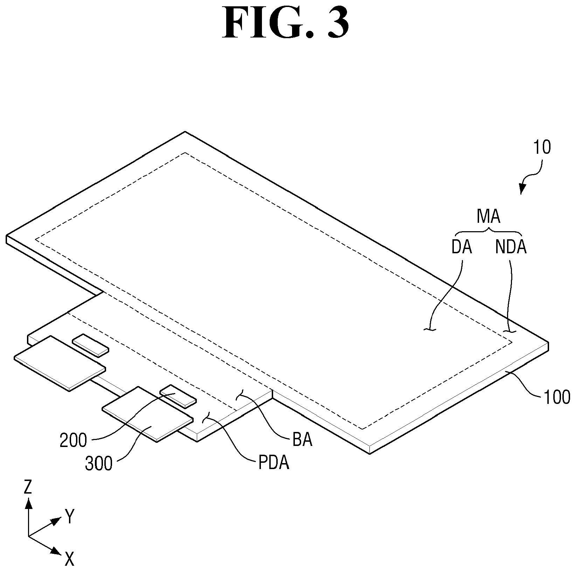

FIG. 3 is a perspective view showing a display device according to some embodiments of the present invention.

Referring to FIG. 3, the shape of the display panel 100 to some embodiments may be different from the shape of the display panel 100 according to the embodiments described above with reference to FIG. 1 and the like.

For example, in the display panel 100 according to some embodiments, the length of the main area MA may be longer than the lengths of the bending area BA and the pad area PDA in the first direction (x-axis direction). The bending area BA and the pad area PDA may protrude from a portion of one side of the main area MA.

As such, the shape of the display panel 100 is not limited to the shapes shown in FIGS. 1 to 3 but various shapes may be applied depending on the type of display device 10.

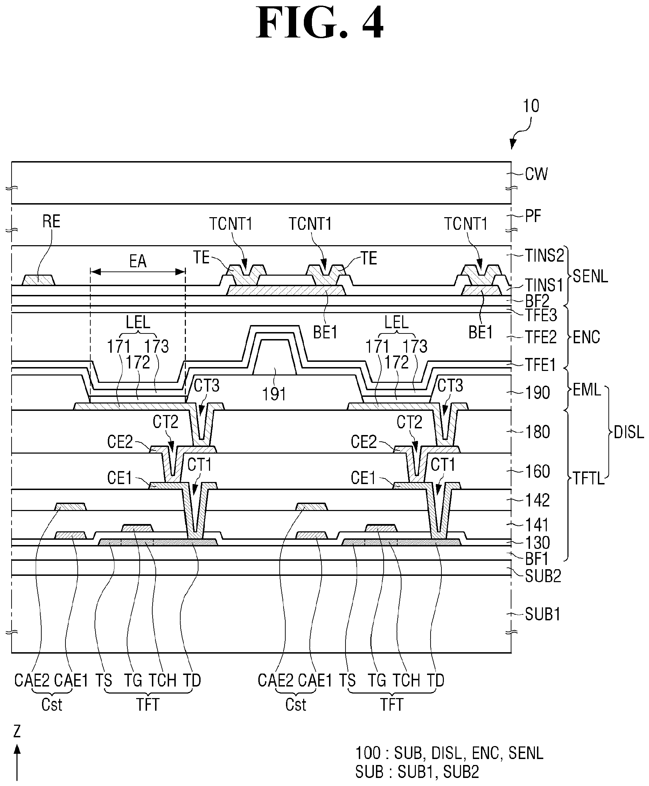

FIG. 4 is a cross-sectional view showing an example of a display area of a display device according to some embodiments of the present invention.

Referring to FIG. 4, the display device 10 may include a display panel 100, a polarizing film PF, and a cover window CW.

The display panel 100 may be an organic light-emitting display panel including light-emitting elements LEL each including an organic emissive layer 172. It should be understood, however, that embodiments according to the present invention are not limited thereto. The display panel 110 may be a light-emitting display panel such as a quantum-dot light-emitting display panel including a quantum-dot emissive layer, an inorganic light-emitting display panel including an inorganic semiconductor, and a micro light-emitting display panel using micro or nano light-emitting diodes (micro LEDs or nano LEDs). In the following description, an organic light-emitting display panel is employed as an example of the display panel 100 for convenience of illustration.

The display panel 100 may include a substrate SUB, a display layer DISL, an encapsulation layer ENC, and a sensor electrode layer SENL.

The substrate SUB may include a first substrate SUB1 made of a rigid material, and a second substrate SUB2 made of a polymer resin made of a flexible material.

The first substrate SUB1 may have a rigid material. For example, the substrate SUB may be made of glass. The substrate SUB may be formed of ultra thin glass (UTG) having a thickness of approximately 500 $\mu$m or less.

The second substrate SUB2 may have a flexible material. The second substrate SUB2 may be made of a polymer resin having a thickness smaller than that of the first substrate SUB1. For example, the second substrate SUB2 may have a thickness of approximately 20 $\mu$m or less. The second substrate SUB2 may be formed of an organic material such as an acryl resin, an epoxy resin, a phenolic resin, a polyamide resin and a polyimide resin. Because the second substrate SUB2 is made of a polymer resin, it may be referred to as a plastic substrate. In some embodiments, the second substrate SUB2 may have a multi-layer structure.

The display layer DISL may include a thin-film transistor layer TFTL including a plurality of thin-film transistors and an emission material layer EML including a plurality of light-emitting elements.

The thin-film transistor layer TFTL may include a first buffer film BF1, a thin-film transistor TFT, a gate insulator 130, a first interlayer dielectric film 141, a capacitor Cst, a second interlayer dielectric film 142, a first data metal layer, a first organic film 160, a second data metal layer, and a second organic film 180.

The first buffer film BF1 may be located on the substrate SUB. The first buffer film BF1 may be formed of an inorganic material such as a silicon nitride layer, a silicon oxynitride layer, a silicon oxide layer, a titanium oxide layer, and an aluminum oxide layer. Alternatively, the first buffer film BF1 may be made up of multiple layers in which two or more of a silicon nitride layer, a silicon oxynitride layer, a silicon oxide layer, a titanium oxide layer and an aluminum oxide layer are stacked on one another.

An active layer including a channel region TCH, a source region TS and a drain region TD of the thin-film transistor TFT may be located on the first buffer film BF1. The active layer may be made of polycrystalline silicon, monocrystalline, low-temperature polycrystalline silicon, amorphous silicon, or an oxide semiconductor. When the active layer includes polycrystalline silicon or an oxide semiconductor material, the source region TS and the drain region TD in the active layer may be conductive regions doped with ions or impurities to have conductivity.

The gate insulator 130 may be located on the active layer of the thin-film transistor TFT. The gate insulator 130 may be formed of an inorganic layer, for example, a silicon nitride layer, a silicon oxynitride layer, a silicon oxide layer, a titanium oxide layer, or an aluminum oxide layer.

A first gate metal layer including a gate electrode TG of the thin-film transistor TFT, a first capacitor electrode CAE1 of a capacitor Cst, and scan lines may be located on the gate insulator 130. The gate electrode G of the thin-film transistor TFT may overlap the channel region TCH in the third direction, in particular az-axis direction. The first gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric film 141 may be located on the first gate metal layer. The first interlayer dielectric film 141 may be formed of an inorganic layer, for example, a silicon nitride layer, a silicon oxynitride layer, a silicon oxide layer, a titanium oxide layer, or an aluminum oxide layer. The first interlayer dielectric film 141 may include a number of inorganic layers.

The second gate metal layer including a second capacitor electrode CAE2 of the capacitor Cst may be located on the first interlayer dielectric film 141. The second capacitor electrode CAE2 may overlap the first capacitor electrode CAE1 in the third direction (z-axis direction). Therefore, the capacitor Cst may be formed by the first capacitor electrode CAE1, the second capacitor electrode CAE2, and an inorganic insulating dielectric film located therebetween and serving as a dielectric film. The second gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric film 142 may be located on the second gate metal layer. The second interlayer dielectric film 142 may be formed of an inorganic layer, for example, a silicon nitride layer, a silicon oxynitride layer, a silicon oxide layer, a titanium oxide layer, or an aluminum oxide layer. The second interlayer dielectric film 142 may include a number of inorganic layers.

The first data metal layer including first connection electrodes CE1 and data lines may be located on the second interlayer dielectric film 142. The first connection electrode CE1 may be connected to the drain region TD through a first contact hole CT1 penetrating the gate insulator 130, the first interlayer dielectric film 141 and the second interlayer dielectric film 142. The first data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first organic film 160 may be arranged over the first connection electrode CE1 for providing a flat surface over the thin-film transistors TFT having uneven heights. The first organic film 160 may be formed as an organic layer such as an acryl resin, an epoxy resin, a phenolic resin, a polyamide resin and a polyimide resin.

A second data metal layer including second connection electrodes CE2 may be located on the first organic film 160. The second data metal layer may be connected to the first connection electrode CE1 through a second contact hole CT2 penetrating the first organic film 160. The second data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second organic film 180 may be located on the second connection electrode CE2. The second organic film 180 may be formed as an organic layer such as an acryl resin, an epoxy resin, a phenolic resin, a polyamide resin and a polyimide resin.

It should be noted that the second data metal layer including the second connection electrodes CE2 and the second organic film 180 may be eliminated.

The emission material layer EML is located on the thin-film transistor layer TFTL. The emission material layer EML may include light-emitting elements LEL and a pixel-defining film 190.

Each of the light-emitting elements LEL may include a pixel electrode 171, an emissive layer 172, and a common electrode 173. In each of the emission areas EA, the pixel electrode 171, the emissive layer 172 and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode.

A pixel electrode layer including the pixel electrode 171 may be formed on the second organic film 180. The pixel electrode 171 may be connected to the second connection electrode CE2 through a third contact hole CT3 penetrating the second organic film 180. The pixel electrode layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

In the top-emission structure where light exits from the emissive layer 172 toward the common electrode 173, the pixel electrode 171 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/Al/ITO), an APC alloy and a stack structure of APC alloy and ITO (ITO/APC/ITO) in order to increase the reflectivity. The APC alloy is an alloy of silver (Ag), palladium (Pd) and copper (Cu).

The pixel-defining film 190 may define the emission areas EA of the pixels. To this end, the pixel-defining film 190 may be formed on the second organic film 180 to expose a part of the pixel electrode 171. The pixel-defining film 190 may cover the edges of the pixel electrode 171. The pixel-defining film 190 may be located inside the third contact hole CT3. In other words, the third contact hole CT3 may be filled with the pixel-defining film 190. The pixel-defining film 190 may be formed of an organic layer such as an acryl resin, an epoxy resin, a phenolic resin, a polyamide resin and a polyimide resin.

A spacer 191 may be located on the pixel-defining film 190. The spacer 191 may support a mask during a process of fabricating the emissive layer 172. The spacer 191 may be formed of an organic layer such as an acryl resin, an epoxy resin, a phenolic resin, a polyamide resin and a polyimide resin.

The emissive layer 172 is formed on the pixel electrode 171. The emissive layer 172 may include an organic material to emit light of a certain color. For example, the emissive layer 172 may include a hole transporting layer, an organic material layer, and an electron transporting layer. The organic material layer may include a host and a dopant. The organic material layer may include a material that emits a light (e.g., a set or predetermined light), and may be formed using a phosphor or a fluorescent material.

The common electrode 173 is formed on the emissive layer 172. The cathode electrode 173 may be formed to cover the emissive layer 172. The common electrode 173 may be a common layer formed across the emission areas EA. A capping layer may be formed on the common electrode 173.

In the top-emission structure, the common electrode 173 may be formed of a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is formed of a semi-transmissive metal material, the light extraction efficiency can be increased by using microcavities.

The encapsulation layer ENC may be located on the emission material layer EML. The encapsulation layer ENC may include one or more inorganic films TFE1 and TFE3 to prevent permeation of oxygen or moisture into the emission material layer EML. In addition, the encapsulation layer ENC may include at least one organic film in order to protect the emission material layer EML from particles such as dust. For example, the encapsulation layer ENC may include a first inorganic encapsulation film TFE1, an organic encapsulation film TFE2 and a second inorganic encapsulation film TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film such as an acryl resin, an epoxy resin, a phenolic resin, a polyamide resin, a polyimide resin, etc.

The sensor electrode layer SENL may be located on the encapsulation layer ENC. The sensor electrode layer SENL may include a second buffer film BF2, a first bridge BE1, a first sensor insulating film TINS1, sensor electrodes TE and RE, and a second sensor insulating film TINS2.

A second buffer film BF2 may be located on the encapsulation layer ENC. The second buffer film BF2 may include at least one inorganic film. For example, the second buffer film BF2 may be made up of multiple layers in which one or more inorganic layers of a silicon nitride layer, a silicon oxynitride layer, a silicon oxide layer, a titanium oxide layer and an aluminum oxide layer are alternately stacked on one another. The second buffer film BF2 may be eliminated.

First bridges BE1 may be located on the second buffer film BF2. The first bridges BE1 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/Al/ITO), an APC alloy and a stack structure of an APC alloy and ITO (ITO/APC/ITO).

A first sensor insulating film TINS1 may be located on the first bridges BE1. The first sensor insulating film TINS1 may be formed of an inorganic layer, for example, a silicon nitride layer, a silicon oxynitride layer, a silicon oxide layer, a titanium oxide layer, or an aluminum oxide layer.

The sensor electrodes, i.e., driving electrodes TE and sensing electrodes RE may be located on the first sensor insulating film TINS1. In addition, dummy patterns may be located on the first sensor insulating film TNIS1. The driving electrodes TE, the sensing electrodes RE and the dummy patterns do not overlap the emission areas EA. The driving electrodes TE, the sensing electrodes RE and the dummy patterns may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/Al/ITO), an APC alloy and a stack structure of an APC alloy and ITO (ITO/APC/ITO).

The second sensor insulating film TINS2 may be located on the driving electrodes TE, the sensing electrodes RE, and the dummy patterns. The second sensor insulating film TINS2 may include at least one of an inorganic film and an organic film. The inorganic film may be a silicon nitride layer, a silicon oxynitride layer, a silicon oxide layer, a titanium oxide layer, or an aluminum oxide layer. The organic film may be an acryl resin, an epoxy resin, a phenolic resin, a polyamide resin and a polyimide resin.

The polarizing film PF may be located on the sensor electrode layer SENL. The polarizing film PF may be located on the display panel 100 in order to reduce reflection of external light. The polarizing film PF may include a first base member, a linear polarizer, a retardation film such as a λ/4 (quarter-wave) plate, and a second base member. The first base member, the retardation film, the linear polarizer and the second base member of the polarizing film PF may be sequentially stacked on the display panel 100.

The cover window CW may be located on the polarizing film PF. The cover window CW may be attached onto the polarizing film PF by a transparent adhesive member such as an optically clear adhesive (OCA) film.

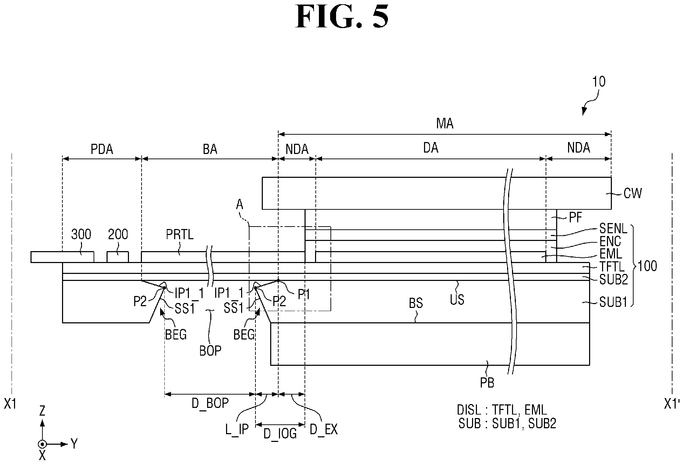

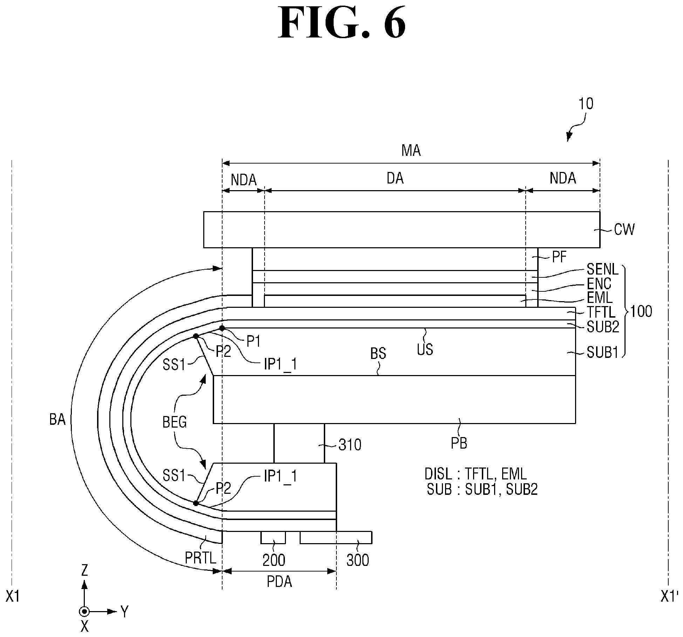

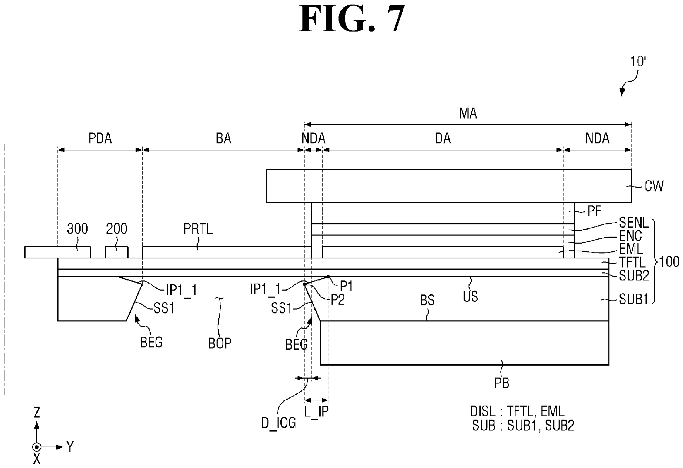

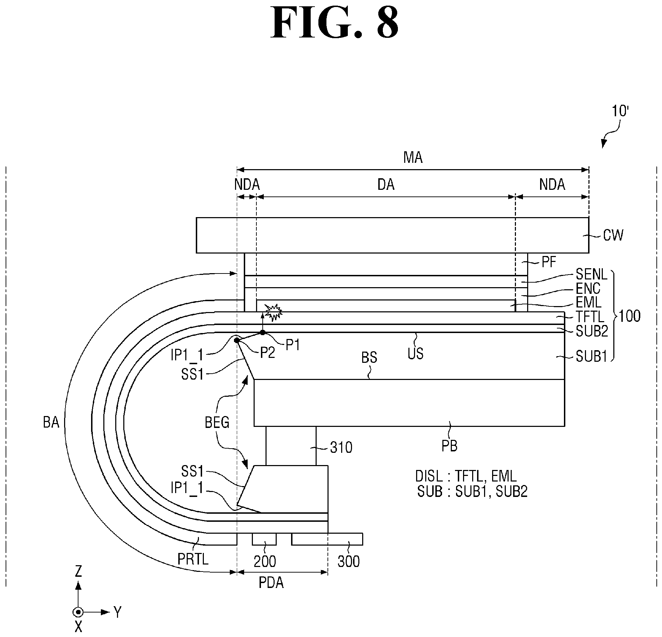

FIG. 5 is a cross-sectional view taken along line X1 - X1' in FIG. 1. FIG. 6 is a cross-sectional view showing the display device according to the embodiments of FIG. 5 when it is bent. FIG. 7 is a cross-sectional view schematically showing a related-art display device. FIG. 8 is a cross-sectional view showing the display device of FIG. 7 when it is bent.

Referring to FIGS. 5 to 8, the display device 10 may further include a protective film PRTL and a panel bottom cover PB, in addition to the display panel 100, the polarizing film PF, the cover window CW, the driver IC 200, and the circuit board 300. The display panel 100 may include a substrate SUB, a display layer DISL, an encapsulation layer ENC, and a sensor electrode layer SENL.

The display layer DISL, the encapsulation layer ENC, the sensor electrode layer SENL, the polarizing film PF and the cover window CW have been described above; and, therefore, the redundant descriptions will be omitted.

The substrate SUB may include a first substrate SUB1 made of a rigid material, and a second substrate SUB2 made of a polymer resin made of a flexible material. The first substrate SUB1 may not be located in the bending area BA. For example, the first substrate SUB1 may include an opening BOP exposing the second substrate SUB2. That is to say, since the first substrate SUB1 made of a rigid material is not located in the bending area BA, it can be easily bent as shown in FIG. 6.

The protective layer PRTL may be located on the thin-film transistor layer TFTL in the bending area BA. The protective layer PRTL may be a layer for protecting the thin-film transistor layer TFTL exposed to the outside in the bending area BA. The protective layer PRTL may be formed of an organic material such as an acryl resin, an epoxy resin, a phenolic resin, a polyamide resin and a polyimide resin.

The panel bottom cover PB may be located on a second surface of the substrate SUB of the display panel 100. The second surface of the substrate SUB may be opposite to the first surface. For example, the panel bottom cover PB may be located on the lower surface BS of the substrate SUB. The panel bottom cover PB may be attached to the second surface of the substrate SUB of the display panel 100 by an adhesive member. The adhesive member may be a pressure-sensitive adhesive (PSA).

The panel bottom cover PB may include at least one of: a light-blocking member for absorbing light incident from outside, a buffer member for absorbing external impact, and a heat dissipating member for efficiently discharging heat from the display panel 100.

The driver IC 200 and the circuit board 300 may be bent such that they are located under the display panel 100, as shown in FIG. 6. The circuit board 300 may be attached to the lower surface of the panel bottom cover PB by an adhesive member 310. The adhesive member 310 may be a pressure-sensitive adhesive.

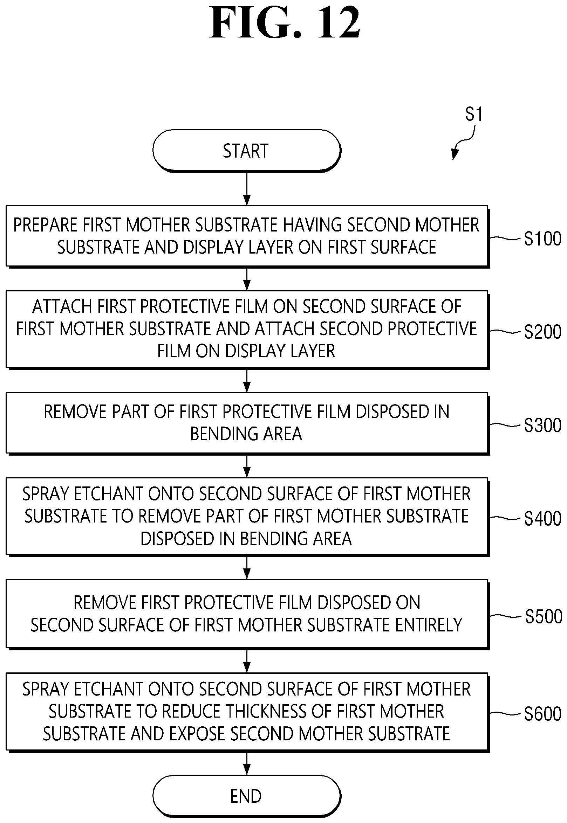

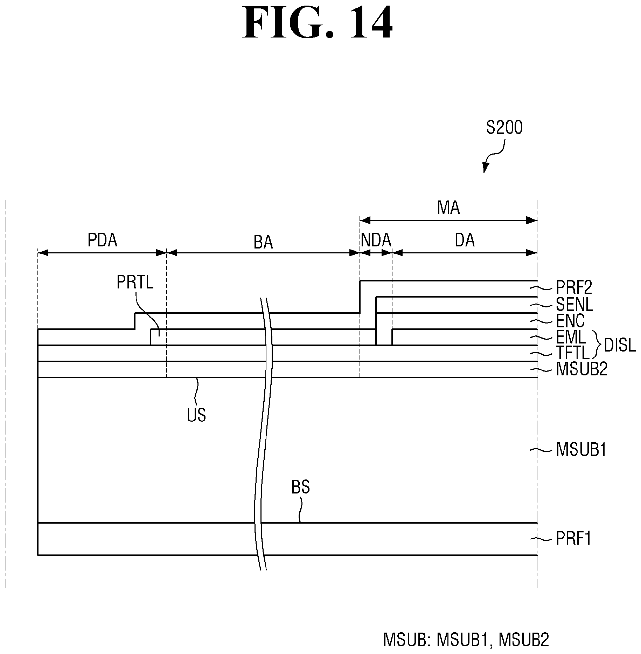

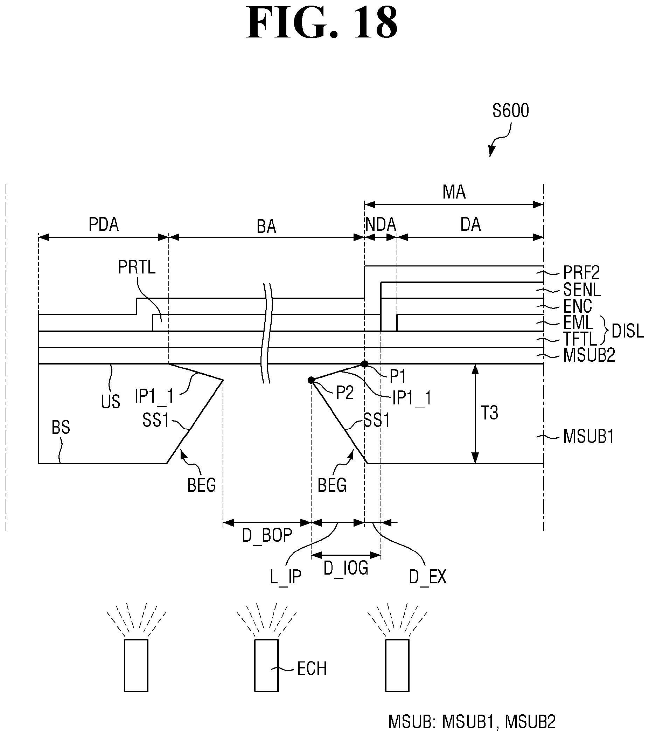

The display device 10 according to some embodiments may include a first side surface SS1 at an edge BEG of the bending area BA. The first side surface SS1 formed at the edge BEG of the bending area BA may be an inclined surface. The inclined surface of the first side surface SS1 may be formed by attaching a first protective film PRF1 (see FIG. 14) to etch a part of the first substrate SUB1 on the bending area BA according to a method S1 of fabricating a display device to be described later (see FIG. 12). The edge BEG of the bending area BA may refer to an edge formed by etching a first mother substrate MSUB1 (see FIG. 18) on the bending area BA according to the method S1 of fabricating a display device to be described later (see FIG. 12).

The first mother substrate MSUB1 may be also called as first substrate SUB1. The second mother substrate MSUB2 may be also called as second substrate SUB2. Thus, the method may be configured to fabricate a display device according to the invention.

More specifically, the first substrate SUB1 may include an upper surface US, a lower surface BS, and a first side surface SS1 and a first inclined surface IP1_1. The upper surface may be also called as first surface US, the lower surface may be called as second surface BS The upper surface US of the first substrate SUB1 may be a side surface in the third direction (z-axis direction), and the lower surface BS may be the opposite side surface in the third direction (z-axis direction).

The first side surface SS1 may be located between the upper surface US and the lower surface BS. The first side surface SS1 may be positioned at the edge BEG of the bending area BA. The first side surface SS1 may be an inclined surface. According to some embodiments of the present invention, the angle formed between the first side surface SS1 and the upper surface US may be an acute angle, and the angle formed between the first side surface SS1 and the lower surface BS may be an obtuse angle. In other words, the first side surface SS1 and the first inclined surface IP1_1 may be protrude in the opening BOP.

The first inclined surface IP1_1 may be located between the upper surface US and the first side surface SS1. The first inclined surface IP1_1 may not contact the second substrate SUB2 in a flat state of the display panel, wherein in particular the first inclined surface IP1_1 may contact the second substrate SUB2 in a bended state of the display panel. The first inclined surface IP1_1 may be an undercut formed between the first substrate SUB1 and the second substrate SUB2. The first inclined surface IP1_1 may be formed as an etchant permeates into the interface between the first substrate SUB1 and the second substrate SUB2 and accordingly the first mother substrate MSUB1 is overly etched, according to the method S1 of fabricating a display device to be described later (see FIG. 12).

The first length L_1P, which is the length of the first inclined surface IP1_1 in the second direction (y-axis direction), may be equal to approximately $73.8 \pm 12.1$ $\mu$m. For example, the average value of the first length L_IP may be 73.8 $\mu$m, and the deviation may be approximately 12.1 $\mu$m. In other words, the first length L_IP may range from 61.7 $\mu$m to 85.9 $\mu$m. The first length L_IP, which is the length of the first inclined surface IP1_1 in the second direction (y-axis direction), may refer to the distance in the second direction (y-axis direction) from an end P2 at an edge BEG of the first substrate SUB1 in the bending area BA to a boundary P1 where the first inclined surface IP1_1 meets the upper surface US of the first substrate SUB1.

In the display device 10 according to some embodiments, the first inclined surface IP1_1 may not overlap with inorganic films included in the display layer DISL, the encapsulation layer ENC and the sensor electrode layer SENL in the third direction (z-axis direction).

For example, the boundary P1 where the first inclined surface IP1_1 and the upper surface US of the first substrate SUB1 meet may not overlap with the inorganic films included in the display layer DISL, the encapsulation layer ENC, and the sensor electrode layer SENL. The boundary P1 where the first inclined surface IP1_1 and the upper surface US of the first substrate SUB1 meet may be spaced apart from the inorganic films included in the display layer DISL, the encapsulation layer ENC and the sensor electrode layer SENL by a first distance D_EX in the second direction (y-axis direction). A process of calculating the first distance D_EX will be described later.

Accordingly, in the display device 10 according to some embodiments, it is possible to prevent cracks in the inorganic films included in the display layer DISL, the encapsulation layer ENC and the sensor electrode layer SENL. That is to say, the first distance D_EX may be a design tolerance for preventing cracks in the inorganic films included in the display layer DISL, the encapsulation layer ENC, and the sensor electrode layer SENL.

As shown in FIG. 6, as the first inclined surface IP1_1 is formed, the bending area BA may be started from the boundary P1 where the first inclined surface IP1_1 meets the upper surface US of the first substrate SUB1, not from the end P2 at the edge BEG of the first substrate SUB1 in the bending area BA. For this reason, in the display device 10 according to some embodiments, the first distance D_EX is ensured so that the first inclined surface IP1_1 does not overlap with the inorganic films included in the display layer DISL, the encapsulation layer ENC and the sensor electrode layer SENL, thereby preventing cracks in the inorganic films in the display layer DISL, the encapsulation layer ENC and the sensor electrode layer SENL.

In contrast, as shown in FIGS. 7 and 8, in a related-art display device 10', an end P2 at an edge BEG of the first substrate SUB1 in the bending area BA may be spaced apart from the inorganic films included in the display layer DISL, the encapsulation layer ENC and the sensor electrode layer SENL by a second distance D_IOG in the second direction (y-axis direction). In the related-art display device 10', the second distance D_IOG may be smaller than the first length L_IP, which is the length of the first inclined surface IP1_1 in the second direction (y-axis direction). Accordingly, the first inclined surface IP1_1 may overlap with inorganic films included in the display layer DISL, the encapsulation layer ENC and the sensor electrode layer SENL in the third direction (z-axis direction).

In the related-art display device 10', even though the bending area BA is designed so that the layers are spaced apart from the end P2 at the edge BEG of the first substrate SUB1 in the bending area BA by the second distance D_IOG, the second substrate SUB2 may be bent also in the main area MA due to the first inclined surface IP1_1. In other words, the part of the second substrate SUB2 in the main area MA may be bent as well. Since the inorganic films included in the display layer DISL, the encapsulation layer ENC and the sensor electrode layer SENL are relatively inflexible, cracks may occur therein when the second substrate SUB2 is bent.

In contrast, as shown in FIGS. 5 and 6, in the display device 10 according to some embodiments, the second distance D_IOG may be greater than the first length L_IP. For example, the second distance D_IOG may be equal to the sum of the first length L_IP and the first distance D_EX. Specifically, in the display device 10 according to some embodiments, taking into account the length of the first inclined surface IP1_1 and the additional design tolerance, the end P2 at the edge BEG of the first substrate SUB1 in the bending area BA is spaced apart from the inorganic films included in the display layer DISL, the encapsulation layer ENC and the sensor electrode layer SENL by the second distance D_IOG, which is the sum of the first length L_IP and the first distance D_EX, thereby preventing cracks in the inorganic films.

More specifically, the second distance D_IOG may be calculated based on the first length L_IP and the first distance D_EX. The first distance D_EX may be calculated based on the deviations of the first length L_IP and the etching tolerance. For example, the second distance D_IOG may be the sum of the first length L_IP and the first distance D_EX.

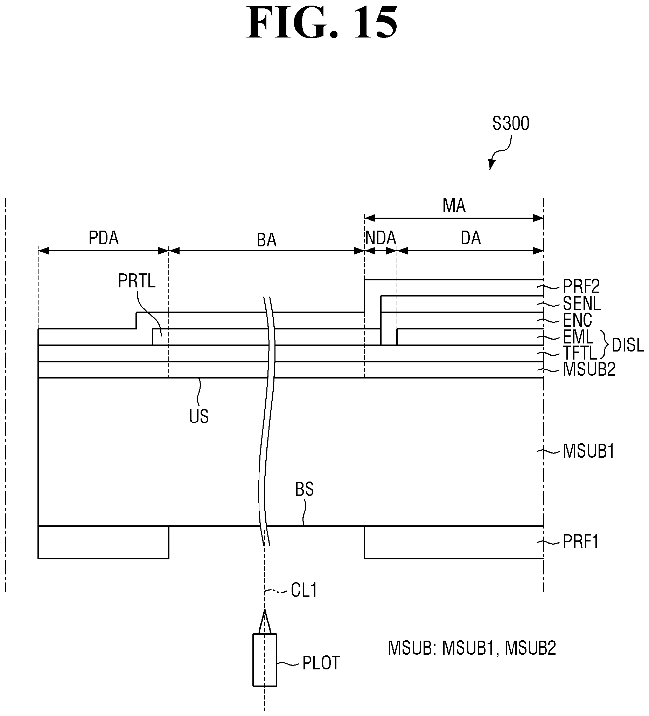

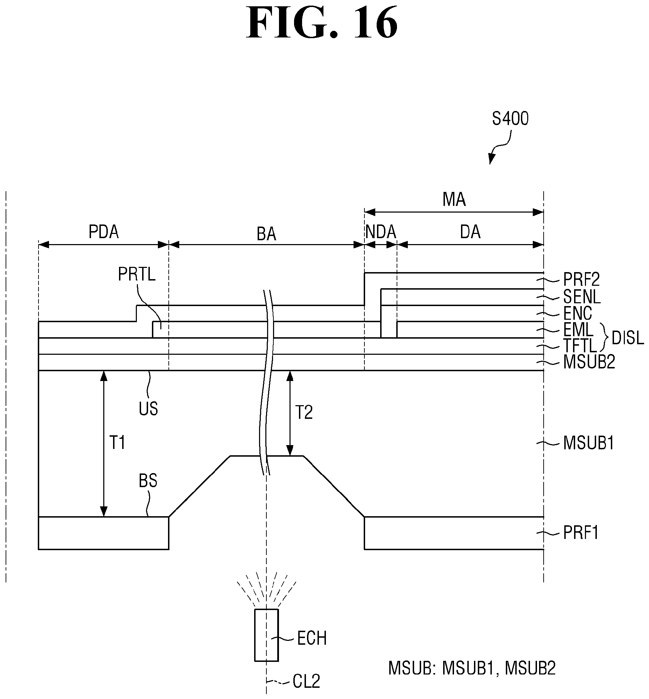

In some embodiments, the minimum value of the second distance D_IOG may be obtained by adding a minimum tolerance to the average of the first length L_IP. In this instance, the minimum tolerance may be the first distance D_EX. For example, the minimum value of the second distance D_IOG may be 88 μm obtained by adding 73.8 μm, which is the average of the first length L_IP, to the minimum tolerance of 14.2 μm. The minimum tolerance may be greater than 12.1 μm, which is the deviation of the first length L_IP. When the etching tolerance is zero, the first distance D_EX may be calculated by additionally adding the minimum design tolerance (approximately 2 μm) to the deviation of the first length L_IP. The etching tolerance may refer to a design tolerance that takes into account the central axis deviation of a plotter PLOT (see FIG. 15) included in Equation 3 described later and the central axis deviation of an etchant supply (see FIG. 16).

In some embodiments, the maximum value of the second distance D_IOG may satisfy Equation 1 below:

### Equation 1

$$Max(D2) = \mu(L1) + 3\sigma(L1) + 3\sigma(D3)$$

where D2 denotes the second distance D_IOG, L1 denotes the first length L_IP, D3 denotes a third distance D_BOP, which is the distance in the second direction (y-axis direction) between the ends P2 at the edges BEG of the first substrate SUB1 in the bending area BA. The maximum value of the second distance D_IOG may be equal to the sum of the average of the first length L_IP ($\mu$(L1)), three times the deviation of the first length L_IP ($3\sigma$(L1)), and three times the deviation of the third distance D_BOP ($3\sigma$(D3)).

In this instance, the first distance D_EX may satisfy Equation 2 below:

### Equation 2

$$D1 = 3\sigma(L1) + 3\sigma(D3)$$

where D1 denotes the value of the first distance D_EX. The first distance D_EX may be the sum of $3\sigma$(L1), which is three times the deviations of the first length (L_IP), and $3\sigma$(D3), which is three times the deviations of the third distance D_BOP. The first distance D_EX may be calculated by adding the three times the deviation of the first length L_IP and the three times the deviation of the third distance D_BOP according to the three-sigma rule of a normal distribution.

The deviation of the third distance D_BOP ($\sigma$(D3)) may be calculated using a central axis deviation of a plotter (PLOT) (see FIG. 15) and a central axis deviation of an etchant supply (see FIG. 16) according to the method S1 of fabricating a display device to be described later. For example, the $\sigma$(D3), which is the deviation of the third distance D_BOP, may satisfy Equation 3 below:

### Equation 3

$$\sigma(D3) = \sqrt{(\sigma_1)^2 + (\sigma_2)^2}$$

where $\sigma_1$ denotes the central axis deviation of the plotter PLOT (see FIG. 15), and $\sigma2$ denotes the central axis deviation of the etchant supply (see FIG. 16). The deviation of the third distance D_BOP ($\sigma$(D3)) may satisfy Equation 3 above. According to some embodiments of the present invention, the central axis deviation $\sigma_1$ of the plotter PLOT (see e. g. FIG. 15) may be approximately 48.22 μm, and the central axis deviation $\sigma2$ of the etchant supply (see FIG. 16) may be approximately 89.32 μm. Accordingly, the deviation of the third distance D_BOP may be approximately 101.5 μm.

According to some embodiments of the present invention, the maximum value of the second distance D_IOG may be approximately 415 μm. For example, as mentioned above, the average of the first length L_IP may be approximately 73.8 μm, the deviation of the first length L_IP may be approximately 12.1 μm, and the deviations of the third distance D_BOP may be approximately 101.5 μm. The maximum value of the second distance D_IOG may be the sum of the average of the second first length L_IP, three times the deviation of the first length L_IP and three times the deviation of the third distance D_BOP, which may be equal to 415 μm.

In the display device 10 according to some embodiments, the first inclined surface IP1_1 does not overlap with the inorganic films included in the display layer DISL, the encapsulation layer ENC and the sensor electrode layer SENL in the third direction (z-axis direction), and the end P2 at the edge BEG of the first substrate SUB1 in the bending area BASE is spaced apart from the inorganic films included in the display layer DISL, the encapsulation layer ENC and the sensor electrode layer SENL by the second distance D_IOG, so that it is possible to prevent cracks in the inorganic films included in the display layer DISL, the encapsulation layer ENC, and the sensor electrode layer SENL, and it is possible to reduce the length of a dead space.

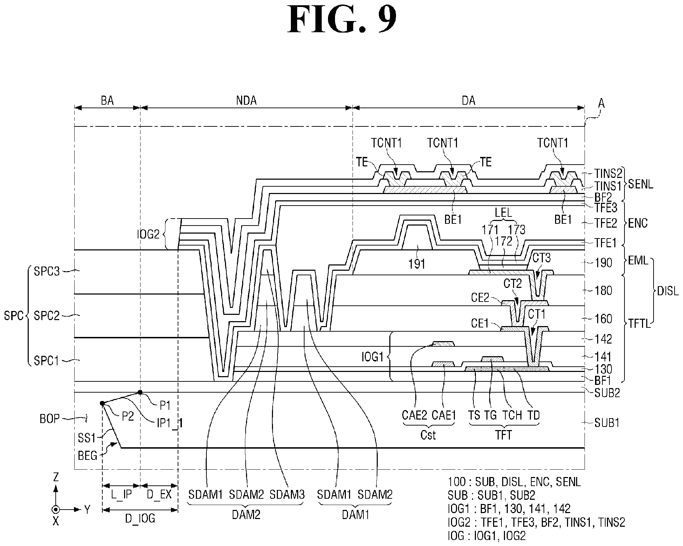

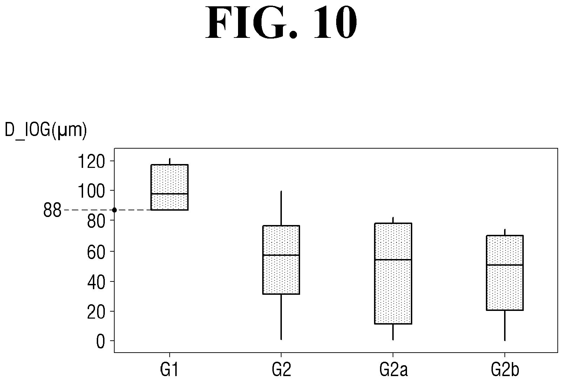

FIG. 9 is an enlarged view of portion A of FIG. 5. FIG. 10 is a graph showing distributions of distances between an end of a first substrate in a bending area and an end of an inorganic film group in experimental groups sorted by whether cracks occur in inorganic films.

Referring to FIGS. 9 and 10 in conjunction with FIGS. 5 and 6, the display panel 100 may include a first dam DAM1 and a second dam DAM2 located in the display area DA and/or the non-display area NDA, and a bank structure SPC located in the non-display area NDA and/or the bending area BA.

The first dam DAM1 and the second dam DAM2 may be located at the outermost position of the display area DA or in the non-display area NDA, and may be arranged to surround at least a part of the display area DA. The first dam DAM1 and the second dam DAM2 can prevent the organic encapsulation film TFE2 of the encapsulation layer ENC from overflowing into the non-display area NDA.

Although the display panel 100 includes two dams in the example shown in the drawings, the present invention is not limited thereto. The display panel 100 may include one dam or three or more dams.

The first dam DAM1 may include a first sub-dam SDAM1 and a second sub-dam SDAM2, and the second dam DAM2 may include a first sub-dam SDAM1, a second sub-dam SDAM2 and a third sub-dam SDAM3. The first sub-dam SDAM1 may include the same material as the first organic film 160 and may be located on the same layer. The second sub-dam SDAM1 may include the same material as the second organic film 180 and may be located on the same layer. The third sub-dam SDAM3 may be located on the second sub-dam SDAM2 and may include the same material as the second sub-dam SDAM2. Alternatively, the third sub-dam SDAM3 may include the same material as the pixel-defining film 190.

The height of the first dam DAM1 may be lower than that of the second dam DAM2. It is, however, to be understood that the present invention is not limited thereto. The height of the first dam DAM1 may be substantially equal to or higher than the height of the second dam DAM2.

The bank structure SPC may be located in the non-display area NDA and/or the bending area BA. The bank structure SPC can protect a variety of underlying lines that are extended from the display area DA to the pad area PDA via the bending area BA. In addition, the bank structure SPC may provide a support space in which a mask for patterning can be seated during the process of stacking the layers of the display panel 100.

The bank structure SPC may include a first bank layer SPC1, a second bank layer SPC2, and a third bank layer SPC3. The first bank layer SPC1 may include the same material as the first organic film 160. The second bank layer SPC2 may include the same material as the second organic film 180. The third bank layer SPC3 may include the same material as the second bank layer SPC2. Alternatively, the third bank layer SPC3 may include the same material as the pixel-defining film 190.

The first dam DAM1 and the second dam DAM2 may be located on the first buffer film BF1, the gate insulator 130, the first interlayer dielectric film 141, and the second interlayer dielectric film 142. The bank structure SPC may be located directly on the second substrate SUB2. Alternatively, the bank structure SPC may be located directly on the first buffer film BF1.

An inorganic film group IOG may include a first inorganic film group IOG1 and a second inorganic film group IOG2.

The first inorganic film group IOG1 may include the first buffer film BF1, the gate insulator 130, the first interlayer dielectric film 141, and the second interlayer dielectric film 142. The first inorganic film group IOG1 may be extended from the display area DA to between the second dam DAM2 and the bank structure SPC. For example, the first inorganic film group IOG1 may be located on one side of the bank structure SPC in the second direction (y-axis direction). The first inorganic film group IOG1 may not overlap with the bank structure SPC in the third direction (z-axis direction).

The second inorganic film group IOG2 may include the first inorganic encapsulation film TFE1, the second inorganic encapsulation layer TFE3, the second buffer film BF2, the first sensor insulating film TINS1, and a second sensor insulating film TINS2. The second inorganic film group IOG2 may be extended from the display area DA to the non-display area NDA beyond the second dam DAM2. The second inorganic film group IOG2 may cover the upper and a side surface of the second dam DAM2. The second inorganic film group IOG2 may be extended to the top surface of the bank structure SPC. For example, the outermost end of the second inorganic film group IOG2 may be located adjacent to the bending area BA on the top surface of the bank structure SPC.

The distance between the boundary P1 where the first inclined surface IP1_1 meets the upper surface US of the first substrate SUB1 and the outermost end of the inorganic film group IOG in the second direction (y-axis direction) may be the first distance D_EX. For example, the distance between the boundary P1 where the first inclined surface IP1_1 meets the upper surface US of the first substrate SUB1 and the outermost end of the second inorganic film group IOG2 in the second direction (y-axis direction) may be the first distance D_EX. The length of the first inclined surface IP1_1 in the second direction (y-axis direction) may be the first length L_IP. The distance in the second direction (y-axis direction) between the end P2 at the edge BEG of the first substrate SUB1 in the bending area BA and the outermost end of the inorganic film group IOG may be the second distance D_IOG. For example, the distance in the second direction (y-axis direction) between the end P2 at the edge BEG of the first substrate SUB1 in the bending area BA and the outermost end of the second inorganic film group IOG2 may be the second distance D_IOG.

The first distance D_EX, the first length L_IP and the second distance D_IOG have been described above, and thus will not be described again to avoid redundancy.

In the display device 10 according to some embodiments, the first inclined surface IP1_1 does not overlap with the first inorganic film group IOG1 or the second inorganic film group IOG2 in the third direction (z-axis direction), and the end P2 at the edge BEG of the first substrate SUB1 in the bending area BA is spaced apart from the outermost end of the inorganic film group IOG in the second direction (y-axis direction) by the second distance D_IOG, so that it is possible to prevent cracks in the inorganic films included in the inorganic film group IOG, and it is possible to reduce the length of a dead space.

The graph of FIG. 10 shows the distributions of the second distance D_IOG of the display panels 100 included in the experimental groups G1, G2, G2a, and G2b, respectively, sorted by whether cracks occur in the inorganic film.

The first experimental group G1 is a set of display panels 100 with no cracks in the inorganic films, while the second experimental group G2 is a set of display panels 100 with cracks in the inorganic films. The (2-1) experimental group G2a represents a set of display panels 100 in which cracks are not propagated to circuits of a thin-film transistor layer TFTL among those of the second experimental group G2. The (2-2) experimental group G2b represents a set of display panels 100 in which cracks are propagated to circuits of a thin-film transistor layer TFTL among those of the second experimental group G2.

In the display panels 100 of the first experimental group G1, the second distance D_IOG may be approximately 88 $\mu$m or more. In the display panels 100 of the second experimental group G2, the second distance D_IOG may be approximately 80 $\mu$m or less. In the display panels 100 of the (2-1) experimental group G2a and the (2-2) experimental group G2b, the average of the second distance D_IOG may be approximately 50 $\mu$m.

As described above with reference to FIG. 5 and the like, the minimum value of the second distance D_IOG calculated by summing the first length L_IP, which is the length of the first inclined surface IP1_1 in the second direction (y-axis direction), and the first distance D_EX reflecting the deviations of the first length L_IP and the etching tolerance may be equal to the minimum value of the second distance D_IOG in the display panels 100 of the first experimental group G1.

As described above, in the display device 10 according to some embodiments, it is possible to prevent cracks in the inorganic films by calculating the minimum value of the second distance D_IOG, and it is possible to reduce the length of the dead space by calculating the maximum value of the second distance D_IOG.

Hereinafter, a display device according to some embodiments of the present invention will be described. In the following description, the same or similar elements will be denoted by the same or similar reference numerals, and redundant descriptions will be omitted or briefly described.

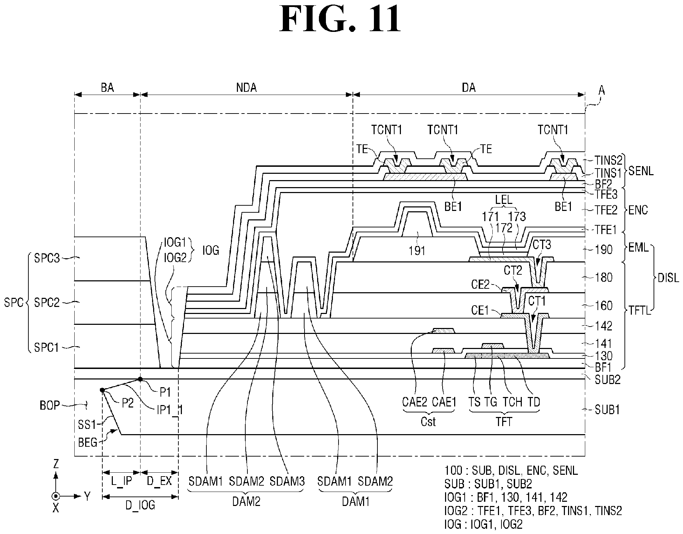

FIG. 11 is a cross-sectional view showing a part of a display area, a non-display area and a bending area of a display device according to some embodiments of the present invention.

A display device 10 according to some embodiments shown in FIG. 11 is different from the display device 10 according to the above-described embodiments of FIG. 9 and the like in that a second inorganic film group IOG2 does not overlap a bank structure SPC in the third direction (z-axis direction).

More specifically, an inorganic film group IOG may include a first inorganic film group IOG1 and a second inorganic film group IOG2.

The first inorganic film group IOG1 may include the first buffer film BF1, the gate insulator 130, the first interlayer dielectric film 141, and the second interlayer dielectric film 142. The first inorganic film group IOG1 may be extended from the display area DA to between the second dam DAM2 and the bank structure SPC. For example, the first inorganic film group IOG1 may be located on one side of the bank structure SPC in the second direction (y-axis direction). The first inorganic film group IOG1 may not overlap with the bank structure SPC in the third direction (z-axis direction).

The second inorganic film group IOG2 may include the first inorganic encapsulation film TFE1, the second inorganic encapsulation layer TFE3, the second buffer film BF2, the first sensor insulating film TINS1, and a second sensor insulating film TINS2. Like the first inorganic film group IOG1, the second inorganic film group IOG2 may be extended from the display area DA to between the second dam DAM2 and the bank structure SPC. For example, the first inorganic film group IOG1 may be located on one side of the bank structure SPC in the second direction (y-axis direction). The first inorganic film group IOG1 may not overlap with the bank structure SPC in the third direction (z-axis direction).

The outermost end of the inorganic film group IOG may be located adjacent to the bending area BA on one side of the bank structure SPC. The distance between the boundary P1 where the first inclined surface IP1_1 meets the upper surface US of the first substrate SUB1 and the outermost end of the inorganic film group IOG in the second direction (y-axis direction) may be the first distance D_EX. For example, the distance between the boundary P1 and the outermost end of the first inorganic film group IOG1 in the second direction (y-axis direction) may be the first distance D_EX. The length of the first inclined surface IP1_1 in the second direction (y-axis direction) may be the first length L_IP. The distance in the second direction (y-axis direction) between the end P2 at the edge BEG of the first substrate SUB1 in the bending area BA and the outermost end of the inorganic film group IOG2 may be the second distance D_IOG. For example, the distance in the second direction (y-axis direction) between the end P2 at the edge BEG of the first substrate SUB1 in the bending area BA and the outermost end of the first inorganic film group IOG1 may be the second distance D_IOG.

In the display device 10 according to some embodiments, the first inclined surface IP1_1 does not overlap with the first inorganic film group IOG1 or the second inorganic film group IOG2 in the third direction (z-axis direction), and the end P2 at the edge BEG of the first substrate SUB1 in the bending area BA is spaced apart from the outermost end of the inorganic film group IOG in the second direction (y-axis direction) by the second distance D_IOG, so that it is possible to prevent cracks in the inorganic films included in the inorganic film group IOG, and it is possible to reduce the length of a dead space.

Although the end of the lowermost inorganic film is the outermost end in each of the first inorganic film group IOG1 and the second inorganic film group IOG2 according to the embodiments described above with reference to FIGS. 9 and 11, the present invention is not limited thereto. For example, the end of the middle layer or the uppermost inorganic film may be the outermost end in each of the first inorganic film group IOG1 and the second inorganic film group IOG2.

Hereinafter, a method of fabricating a display device according to some embodiments of the present invention will be described.

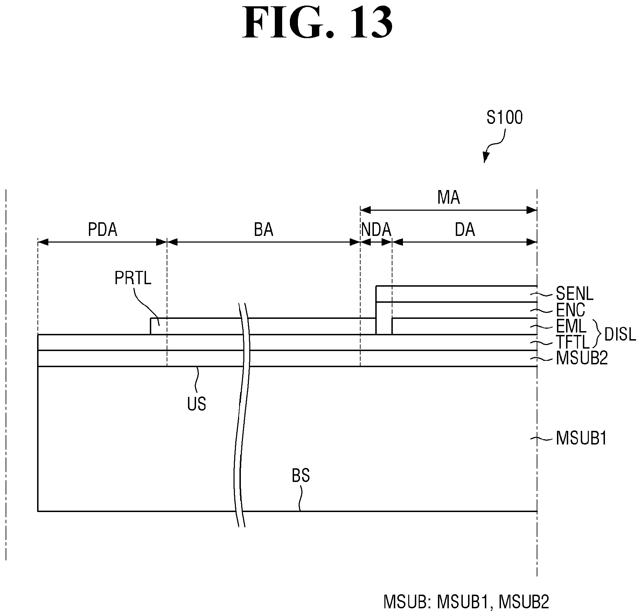

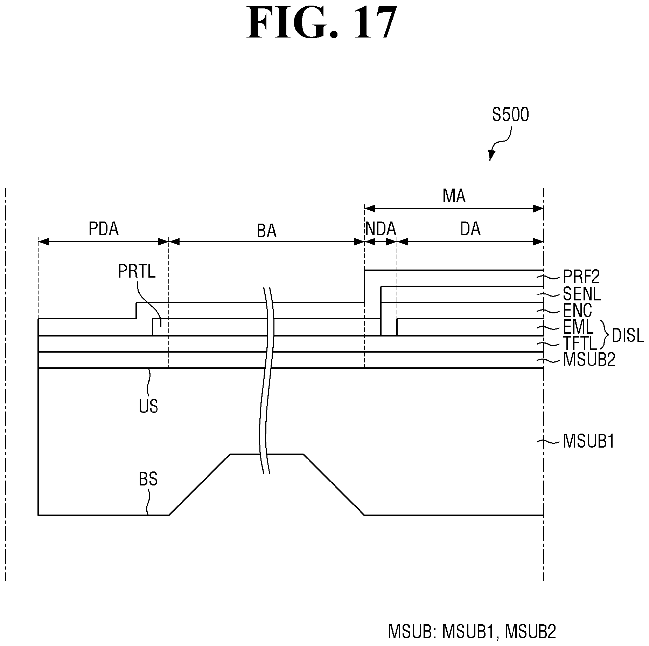

FIG. 12 is a flowchart for illustrating a method of fabricating a display device according to some embodiments of the present invention. FIG. 13 is a cross-sectional view showing step S100 of FIG. 12. FIG. 14 is a cross-sectional view showing step S200 of FIG. 12. FIG. 15 is a cross-sectional view showing step S300 of FIG. 12. FIG. 16 is a cross-sectional view showing step S400 of FIG. 12. FIG. 17 is a cross-sectional view showing step S500 of FIG. 12. FIG. 18 is a cross-sectional view showing step S600 of FIG. 12.

Referring to FIGS. 12 to 18, the method S1 of fabricating a display device according to some embodiments may include, first, forming a second mother substrate MSUB2 and a display layer DISL on an upper surface US of a first mother substrate MSUB1(step S100 of FIG. 12), as shown in FIG. 13.

For example, a mother substrate MSUB may include the first mother substrate MSUB1 and the second mother substrate MSUB2. The second mother substrate MSUB2 may be formed on the upper surface US of the first mother substrate MSUB1. Subsequently, the display layer DISL may be formed on the second mother substrate MSUB2, and an encapsulation layer ENC and a sensor electrode layer SENL may be further formed.

Second, as shown in FIG. 14, a first protective film PRF1 may be attached on a lower surface BS of the first mother substrate MSUB1, and a second protective film PRF2 may be attached on the display layer DISL (step S200 of FIG. 12).

For example, the first protective film PRF1 may be attached to the entire lower surface BS of the first mother substrate MSUB1. When the encapsulation layer ENC and the sensor electrode layer SENL are located on the display layer DISL, the second protective film PRF2 may be attached on the sensor electrode layer SENL. The second protective film PRF2 may cover the display layer DISL, the encapsulation layer ENC, and the sensor electrode layer SENL altogether.

The first protective film PRF1 and the second protective film PRF2 may be acid-resistant films. The first protective film PRF1 can prevent the first mother substrate MSUB1 from being etched where the first protective film PRF1 is attached. The second protective film PRF2 can protect the display layer DISL from an etchant ECH.

Thirdly, as shown in FIG. 15, a part of the first protective film PRF1 located in a bending area BA may be removed (step S300 of FIG. 12).

For example, a plotter PLOT for removing the first protective film PRF1 may be placed on the lower surface BS of the first mother substrate MSUB1. The plotter PLOT may be a film removal device configured to cut and detach the film.

The plotter PLOT may be located at the center of the bending area BA. A first central axis CL1, which is an extension of the central portion of the plotter PLOT, may be located substantially coincident with the center of the bending area BA. In some implementations, the first central axis CL1 may be distant from the center of the bending area BA by a distance (e.g., a set or predetermined distance). In this instance, the deviation of the first central axis CL1 of the plotter PLOT may be used to calculate the third distance D_BOP as in Equation 3 above.

A part of the lower surface BS of the first mother substrate MSUB1 may be exposed in the bending area BA where the first protective film PRF1 is removed.

Fourthly, as shown in FIG. 16, the etchant ECH is sprayed on the lower surface BS of the first mother substrate MSUB1 so that the first mother substrate MSUB1 located in the bending area BA may be partially removed (step S400 in FIG. 12).

For example, an etchant supply for spraying the etchant ECH may be placed on the lower surface BS of the first mother substrate MSUB1.

The etchant supply may be located at the center of the bending area BA. A second central axis CL2, which is an extension of the center of the plotter PLOT, may be located substantially in line with the center of the bending area BA. In some implementations, the second central axis CL2 may be distant from the center of the bending area BA by a distance (e.g., a set or predetermined distance). In this instance, the deviation of the second central axis CL2 of the etchant supply may be used to calculate the third distance D_BOP as in Equation 3 above.

As a part of the first mother substrate MSUB1 is removed in the bending area BA, there may be differences in thickness between the etched area and the non-etched area. For example, a second thickness T2 of the first mother substrate MSUB1 in the bending area BA may be smaller than a first thickness T of the first mother substrate MSUB1 in the other area than the bending area BA. The second thickness T2 may be approximately 0.5 to 0.7 times the first thickness T1.

After a part of the first mother substrate MSUB1 is etched, inclined surfaces may be formed in the bending area BA. Such inclined surfaces may be formed by isotropic nature of wet etching.

Fifthly, as shown in FIG. 17, the entirety of the first protective film PRF1 located on the lower surface BS of the first mother substrate MSUB1 may be removed. Accordingly, the entire lower surface BS of the first mother substrate MSUB1 may be exposed (step S500 of FIG. 12).

Sixthly, as shown in FIG. 18, the overall thickness of the first mother substrate MSUB1 may be reduced by spraying the etchant ECH onto the lower surface BS of the first mother substrate MSUB1, and the second mother substrate MSUB2 located on the first mother substrate MSUB1 may be exposed (step S600 of FIG. 12).

By spraying the etchant onto the lower surface BS of the first mother substrate MSUB1, the first thickness T1 of the first mother substrate MSUB1 can be reduced to the third thickness T3. The first thickness T1 may be approximately 500 $\mu$m, and the third thickness T3 may be approximately 200 $\mu$m, but the present invention is not limited thereto.

Since the first mother substrate MSUB1 is etched without any mask, the entire lower surface BS of the first mother substrate MSUB1 can be etched uniformly (isotropic etch). As a result, the first side surface SS1 may be formed as an inclined surface at the edge EG of the first substrate MSUB1 in the bending area BA along the inclined surface formed in step S400.

As the thickness of the first mother substrate MSUB1 decreases, a part of the first mother substrate MSUB1 that is located at the bending area BA may be completely etched, and thus the second mother substrate MSUB2 may be exposed. Even after the second mother substrate MSUB2 is exposed, the first mother substrate MSUB1 may be overly etched to completely remove the part of the first mother substrate MSUB1 that is located in the bending area BA. In doing so, the etchant ECH may permeate into the interface between the second mother substrate MSUB2 and the first mother substrate MSUB1. As a result, the first inclined surface IP1_1 may be formed.

In the method S1 according to some embodiments, the first inclined surface IP1_1 does not overlap with the inorganic films included in the display layer DISL, the encapsulation layer ENC and the sensor electrode layer SENL in the third direction (z-axis direction), and the end P2 at the edge BEG of the first substrate SUB1 in the bending area BASE is spaced apart from the inorganic films included in the display layer DISL, the encapsulation layer ENC and the sensor electrode layer SENL by the second distance D_IOG, so that it is possible to prevent cracks in the inorganic films included in the display layer DISL, the encapsulation layer ENC, and the sensor electrode layer SENL, and it is possible to reduce the length of a dead space.

In concluding the detailed description, those skilled in the art will appreciate that many variations and modifications can be made to the disclosed embodiments without substantially departing from the principles of embodiments according to the present invention. Therefore, the disclosed embodiments of the invention are used in a generic and descriptive sense only and not for purposes of limitation.

**Claims**

**1.** A display device (10) comprising:

a first substrate (SUB1) comprising a first surface and a second surface facing each other and having a rigid material;
a second substrate (SUB2) on the first surface of the first substrate (SUB1) and having a flexible material; and
a display layer (DISL) on the second substrate (SUB2) and comprising at least one inorganic film and a plurality of light-emitting elements (LEL), wherein
the first substrate (SUB1), at an edge (BEG) of a bending area (BA) where the second substrate (SUB2) is bent, further comprises:

a first side surface (SS1) between the first surface and the second surface; and
a first inclined surface (IP1_1) between the first surface and the first side surface (SS1), and
the at least one inorganic film does not overlap with the first inclined surface (IP1_1).

**2.** A display device (10) comprising:

a first substrate (SUB1) comprising a first surface and a second surface facing each other and having a rigid material;

a second substrate (SUB2) on the first surface of the first substrate (SUB1) and having a flexible material;
a display layer (DISL) on the second substrate (SUB2) and comprising at least one display inorganic film and a plurality of light-emitting elements (LEL);
an encapsulation layer (ENC) on the display layer (DISL) and comprising at least one encapsulation inorganic film; and
a sensor layer on the encapsulation layer (ENC) and comprising at least one sensor inorganic film, wherein the display inorganic film, the inorganic encapsulation film (TFE1, TFE3), and the sensor inorganic film constitute an inorganic film group (IOG),
the first substrate (SUB1), at an edge (BEG) of a bending area (BA) where the second substrate (SUB2) is bent, further comprises:

a first side surface (SS1) between the first surface and the second surface; and
a first inclined surface (IP1_1) between the first surface and the first side surface (SS1), and
the inorganic film group (IOG) does not overlap with the first inclined surface (IP1_1).

3. The display device (10) of claim 1 or 2, wherein the at least one inorganic film does not overlap with the bending area (BA).

4. The display device (10) of at least one of claims 1 or 3, wherein

the first substrate (SUB1) further comprises an opening (BOP) exposing the second substrate (SUB2), and
the edge (BEG) of the bending area (BA) is located on each of both sides of the opening (BOP).

5. The display device (10) of at least one of claims 1 to 4, wherein an outermost end of the at least one inorganic film, the outermost end adjacent to the bending area (BA), is spaced apart from a boundary (P1) where the first inclined surface (IP1_1) meets the first surface by a first distance (D_EX) in a horizontal direction.

6. The display device (10) of at least one of claims 1 to 5, wherein an end of the first substrate (SUB1) in the bending area (BA) is spaced apart from the outermost end of the at least one inorganic film by a second distance (D_IOG) in the horizontal direction.

7. The display device (10) of claim 6, wherein a length of the first inclined surface (IP1_1) in the horizontal direction is a first length (L_IP), and the second distance (D_IOG) is equal to a sum of the first distance (D_EX) and the first length (L_IP).

8. The display device (10) of at least one of claims 6 or 7, wherein a minimum value of the second distance (D_IOG) is equal to a sum of the first distance (D_EX) and an average of the first length (L_IP).

9. The display device (10) of claim 1 and at least one of claims 6 to 8, wherein the minimum value of the second distance (D_IOG) is equal to 88 $\mu$m.

10. The display device (10) of claim 1 and at least one of claims 7 to 9, wherein the first distance (D_EX) is equal to 14.2 $\mu$m, and the average of the first length (L_IP) is equal to 73.8 $\mu$m.

11. The display device (10) of at least one of claims 6 to 10, wherein

a distance between ends at edges of the first substrate (SUB1) in the bending area (BA) is a third distance (D_BOP),
a maximum value of the second distance (D_IOG) satisfies Equation 1 below:

Equation 1

$$\text{Max(D2)} = \mu(L1) + 3\sigma(L1) + 3\sigma(D3),$$

and
Max(D2) denotes the maximum value of the second distance (D_IOG), $\mu$(L1) denotes an average of the first length (L_IP), $\sigma$(L1) denotes a deviation of the first length (L_IP), and $\sigma$(D3) denotes a deviation of the third distance (D_BOP).

12. The display device (10) of claim 1 and at least one of claims 6 to 11, wherein the maximum value of the second distance (D_IOG) is equal to 415 $\mu$m.

13. The display device (10) of claim 1 and at least one of claims 7 to 12, wherein the average of the first length (L_IP) is 73.8 $\mu$m, and a deviation of the first length (L_IP) is 12.1 $\mu$m.

14. The display device (10) of at least one of claims 1 to 13, wherein the first distance (D_EX) satisfies Equation 2 below:

## Equation 2

$$D1 = 3\sigma(L1) + 3\sigma(D3).$$

15. The display device (10) of at least one of claims 11 to 14, wherein the deviation of the third distance (D_BOP) satisfies Equation 3 below in a process of etching the first substrate (SUB1) located in the bending area (BA):

## Equation 3

$$\sigma(D3) = \sqrt{(\sigma_1)^2 + (\sigma_2)^2},$$

and
wherein $\sigma_1$ denotes a central axis deviation of a plotter (PLOT) configured to remove a part of a protective film (PRTL) attached on the second surface of the first substrate (SUB1), and $\sigma2$ denotes a central axis deviation of an etchant supply configured to etch the first substrate (SUB1).

16. The display device (10) of claim 1 and at least one of claims 11 to 15, wherein a deviation of the third distance (D_BOP) is equal to 101.5 $\mu$m.

17. The display device (10) of claim 1 and at least one of claims 15 or 16, wherein the central axis deviation of the plotter (PLOT) is equal to 48.22 $\mu$m, and the central axis deviation of the etchant supply is equal to 89.32 $\mu$m.

18. The display device (10) of at least one of claims 1 or 3 to 17, further comprising:

an encapsulation layer (ENC) on the display layer (DISL) and comprising at least one inorganic encapsulation film (TFE1, TFE3),
wherein the at least one inorganic encapsulation film (TFE1, TFE3) does not overlap with the first inclined surface (IP1_1).

19. The display device (10) of claim 1 and claim 18, further comprising:

a sensor layer on the encapsulation layer (ENC) and comprising at least one sensor inorganic film,
wherein the at least one sensor inorganic film does not overlap with the first inclined surface (IP1_1).

20. The display device (10) of at least one of claims 1 to 19, wherein the first substrate (SUB1) comprises glass, and the second substrate (SUB2) comprises a polymer resin.

21. The display device (10) of at least one of claims 2 to 20, further comprising:

a display area (DA) in which the plurality of light-emitting elements (LEL) is located;
a non-display area (NDA) between the display area (DA) and the bending area (BA);
a first dam (DAM1) between the plurality of light-emitting elements (LEL) and the bending area (BA); and
a bank structure (SPC) in at least one of the non-display area (NDA) and the bending area (BA).

22. The display device (10) of at least one of claims 2 to 21, wherein

the inorganic film group (IOG) comprises a first inorganic film group (IOG1) and a second inorganic film group (IOG2),
the first inorganic film group (IOG1) comprises the at least one display inorganic film,
the second inorganic film group (IOG2) comprises at least one of the at least one inorganic encapsulation film (TFE1, TFE3) and the at least one sensor inorganic film,
the first inorganic film group (IOG1) does not overlap with the bank structure (SPC), and
the second inorganic film group (IOG2) overlaps with the bank structure (SPC).

# FIG. 1

# FIG. 2

# FIG. 3

# FIG. 4

# FIG. 5

# FIG. 6

# FIG. 7

# FIG. 8

# FIG. 9

100 : SUB, DISL, ENC, SENL
SUB : SUB1, SUB2
IOG1 : BF1, 130, 141, 142
IOG2 : TFE1, TFE3, BF2, TINS1, TINS2
IOG : IOG1, IOG2

# FIG. 10

# FIG. 11

# FIG. 12

S1

```
┌─────────────────┐
│      START      │
└─────────────────┘
```

PREPARE FIRST MOTHER SUBSTRATE HAVING SECOND MOTHER SUBSTRATE AND DISPLAY LAYER ON FIRST SURFACE — S100

ATTACH FIRST PROTECTIVE FILM ON SECOND SURFACE OF FIRST MOTHER SUBSTRATE AND ATTACH SECOND PROTECTIVE FILM ON DISPLAY LAYER — S200

REMOVE PART OF FIRST PROTECTIVE FILM DISPOSED IN BENDING AREA — S300

SPRAY ETCHANT ONTO SECOND SURFACE OF FIRST MOTHER SUBSTRATE TO REMOVE PART OF FIRST MOTHER SUBSTRATE DISPOSED IN BENDING AREA — S400

REMOVE FIRST PROTECTIVE FILM DISPOSED ON SECOND SURFACE OF FIRST MOTHER SUBSTRATE ENTIRELY — S500

SPRAY ETCHANT ONTO SECOND SURFACE OF FIRST MOTHER SUBSTRATE TO REDUCE THICKNESS OF FIRST MOTHER SUBSTRATE AND EXPOSE SECOND MOTHER SUBSTRATE — S600

```
┌─────────────────┐
│       END       │
└─────────────────┘
```

# FIG. 13

MSUB: MSUB1, MSUB2

# FIG. 14

MSUB: MSUB1, MSUB2

# FIG. 15

S300

MA

PDA | BA | NDA | DA

PRTL

PRF2
SENL
ENC
EML } DISL
TFTL
MSUB2

US

MSUB1

BS

PRF1

CL1

PLOT

MSUB: MSUB1, MSUB2

# FIG. 16

S400

MA

PDA        BA        NDA        DA

PRTL        PRF2
           SENL
           ENC
           EML    } DISL
US         TFTL
           MSUB2

T1    T2

BS        MSUB1

PRF1

ECH

CL2

MSUB: MSUB1, MSUB2

# FIG. 17

MSUB: MSUB1, MSUB2

# FIG. 18

MSUB: MSUB1, MSUB2

**EUROPEAN SEARCH REPORT**

Application Number

EP 24 18 4842

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/184171 A1 (OHARA HIROKI [JP]) 17 June 2021 (2021-06-17) * claims 1-3; figures 1, 6, 9 * ----- | 1-22 | INV. H10K59/40 H10K59/80 H10K59/88 H10K77/10 |
| X | US 2022/102468 A1 (LEE SANGHOON [KR] ET AL) 31 March 2022 (2022-03-31) * claims 1-25; figures 1, 8, 9A * ----- | 1,3-6 | |

**TECHNICAL FIELDS SEARCHED (IPC)**

H10K

The present search report has been drawn up for all claims

| Place of search | Date of completion of the search | Examiner |
|---|---|---|
| The Hague | 8 November 2024 | Parashkov, Radoslav |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 4842

This annex lists the patent family members relating to the patent documents cited in the above-mentioned European search report.
The members are as contained in the European Patent Office EDP file on
The European Patent Office is in no way liable for these particulars which are merely given for the purpose of information.

08-11-2024

| Patent document cited in search report | | Publication date | Patent family member(s) | | Publication date |
|---|---|---|---|---|---|
| US 2021184171 | A1 | 17-06-2021 | CN | 112640578 A | 09-04-2021 |
| | | | JP | 7150527 B2 | 11-10-2022 |
| | | | JP | 2020035704 A | 05-03-2020 |
| | | | US | 2021184171 A1 | 17-06-2021 |
| | | | WO | 2020044690 A1 | 05-03-2020 |
| US 2022102468 | A1 | 31-03-2022 | CN | 112689913 A | 20-04-2021 |
| | | | EP | 3968402 A1 | 16-03-2022 |
| | | | KR | 20200130571 A | 19-11-2020 |
| | | | US | 2022102468 A1 | 31-03-2022 |
| | | | WO | 2020226267 A1 | 12-11-2020 |

EPO FORM P0459

For more details about this annex : see Official Journal of the European Patent Office, No. 12/82